Europäisches Patentamt

European Patent Office

Office européen des brevets

(11) Numéro de publication: **0014108**
**A1**

## (12) DEMANDE DE BREVET EUROPEEN

(21) Numéro de dépôt: **80400012.3**

(22) Date de dépôt: **04.01.80**

(51) Int. Cl.³: **H 03 K 4/83**

(30) Priorité: **09.01.79 FR 7900420**

(43) Date de publication de la demande: **06.08.80**
**Bulletin 80/16**

(84) Etats contractants désignés: **CH DE GB IT**

(71) Demandeur: **"THOMSON-BRANDT"**, 173, bld
Haussmann, F-75360 Paris Cedex 08 (FR)

(72) Inventeur: **Sheperd, John, "THOMSON-CSF"** -
SCPI 173, bld Haussmann, F-75360 Paris Cedex 08 (FR)

(74) Mandataire: **Thierr, Francoise et al, "THOMSON-CSF"** -
SCPI 173, bld Haussmann, F-75360 Paris Cedex 08 (FR)

(54) **Circuit de balayage-ligne pour récepteur de télévision.**

(57) Le circuit comprenant un premier thyristor (4) de balayage est commandé à l'aide d'un circuit de commutation (10)
comportant un deuxième thyristor (11) et un circuit capacitif
(9), alimenté par une source (6) qui est reliée au circuit de balayage par une inductance (8).

Le signal de gâchette du premier thyristor (4) est élaboré
à partir du signal disponible entre l'inductance (8) et le réseau
capacitif (9) au lieu d'être prélevé à une sortie de l'oscillateur
ligne.

EP 0 014 108 A1

1

# CIRCUIT DE BALAYAGE-LIGNE POUR RÉCEPTEUR DE TÉLÉVISION

L'invention concerne un circuit de balayage-ligne d'un récepteur de télévision, comprenant des thyristors.

Elle constitue un perfectionnement aux circuits décrits dans les brevets français n° 1.536.025 et 72.41492 déposés respectivement les 6 septembre 1967 et 22 novembre 1972.

Le circuit fondamental de balayage horizontal comprend essentiellement : une source, un premier dispositif de commutation composé de l'inductance constituée par la bobine de déviation montée en série avec un condensateur de forte capacité, et un premier couple thyristor-diode fonctionnant comme interrupteur de balayage, et un deuxième dispositif de commutation composé d'un circuit réactif constitué d'une inductance et d'un réseau capacitif, et d'un deuxième couple thyristor-diode faisant passer un courant oscillant dans l'interrupteur de balayage, de manière à permettre l'annulation du courant dans le premier thyristor en assurant en même temps le transfert de l'énergie de la source vers la bobine de balayage associée à son condensateur.

La gâchette du second thyristor est couplée à l'oscillateur ligne du récepteur.

L'invention concerne la façon d'élaborer le signal de gâchette du premier thyristor fonctionnant comme interrupteur de balayage.

Plusieurs solutions existent actuellement.

La gâchette est attaquée directement par un circuit actif, tel que l'oscillateur de ligne (horizontal). Dans une première solution utilisant un couplage capacitif, il est nécessaire de disposer d'une tension d'alimentation continue de valeur élevée (25 volts).

Dans une seconde solution, en liaison directe, une tension d'alimentation continue fortement négative (- 25 volts) devient nécessaire. Au démarrage il est difficile d'obtenir rapidement ces tensions.

Une autre solution consiste à utiliser le signal formé sur l'inductance réunissant le deuxième dispositif de commutation à la source de tension d'alimentation continue. Ce signal qui est positif préalablement à la conduction du premier thyristor, devient négatif pendant le temps de récupération de celui-ci et le retour de ligne. Le prélèvement de ce signal nécessite un enroulement auxiliaire couplé à cette inductance réunissant le circuit de balayage à la source d'alimentation. Dans une variante de cette solution on utilise une régulation active en série avec ladite inductance. Mais dans ce cas, la tension disponible pour l'attaque de la gâchette tombe à zéro pendant la période d'ouverture de l'élément actif de régulation, et le fonctionnement devient incertain.

Une troisième solution consiste à utiliser un réseau d'amortissement et de protection, constitué par une résistance et un condensateur en série, montés en parallèle avec le deuxième couple thyristor-diode, ce réseau étant destiné à protéger le thyristor en diminuant le gradient de la tension qui lui est appliquée. On prend alors la tension existant aux bornes du condensateur pour attaquer la gâchette du premier thyristor. Mais alors le courant nécessaire à son ouverture traverse la résistance montée en série avec le condensateur et, de ce fait, la puissance dissipée dans celle-ci devient prohibitive.

On voit que toutes ces solutions présentent divers inconvénients : dissipation d'énergie, sensibilité à la régulation et incertitude du fonctionnement au démarrage, augmentation du nombre des composants.

L'objet de l'invention est un circuit de balayage-ligne à thyristors, qui ne présente pas ces inconvénients.

En effet, le circuit de balayage ligne selon l'invention comporte :

- une bobine de déviation ligne connectée en série avec un condensateur d'aller de balayage,
- un premier interrupteur bidirectionnel comportant un thyristor et une diode montés tête-bêche, ce premier interrupteur étant connecté en parallèle avec l'ensemble formé par le déviateur ligne et le condensateur d'aller de balayage,
- un second interrupteur bidirectionnel comportant un thyristor et une diode montés tête-bêche, et commandé par un signal provenant d'un circuit oscillateur à la fréquence ligne,
- un circuit réactif comportant une première inductance en série avec un réseau capacitif, et liant électriquement la jonction anode du thyristor et cathode de la diode du premier interrupteur à la jonction anode du thyristor et cathode de la diode du second interrupteur, ladite jonction du second interrupteur étant d'autre part connectée à une source de tension continue au travers d'une seconde inductance, et ce second interrupteur permettant lorsqu'il est en position fermée, d'une part le passage d'un courant oscillant dans le premier interrupteur de manière à permettre l'annulation du courant dans le thyristor de ce premier interrupteur, et d'autre part le transfert de l'énergie de la source vers la bobine de balayage ligne associée au condensateur d'aller de balayage,

et est caractérisé en ce que le premier interrupteur est commandé sur la gâchette de son thyristor par un signal élaboré à partir du signal disponible à la jonction de la première inductance et du réseau capacitif du circuit réactif.

L'invention sera mieux comprise et d'autres caractéristiques apparaîtront au cours de la description de divers modes de réalisation, donnée ci-après avec les figures annexées qui représentent :

- la figure 1, le schéma de principe d'un circuit selon l'invention ;
- la figure 2, les diagrammes de tensions et de courants en divers points du circuit précédent ;
- les figures 3a, 3b, 3c et 3d, les schémas de principe de différentes réalisations du réseau capacitif, connues en soi ;
- les figures 4a, 4b et 4c, les schémas de principe partiels de variantes du circuit de balayage illustrant les divers modes de réalisation du circuit de couplage passif de la gâchette du thyristor de balayage, suivant l'invention ; et
- la figure 5, une variante de réalisation du circuit de couplage de la gâchette du thyristor de balayage, lorsque l'on utilise un transformateur d'isolement 38 pour séparer galvaniquement le circuit de balayage ou d'aller, de la source d'alimentation continue et donc du circuit de commutation ou de retour.

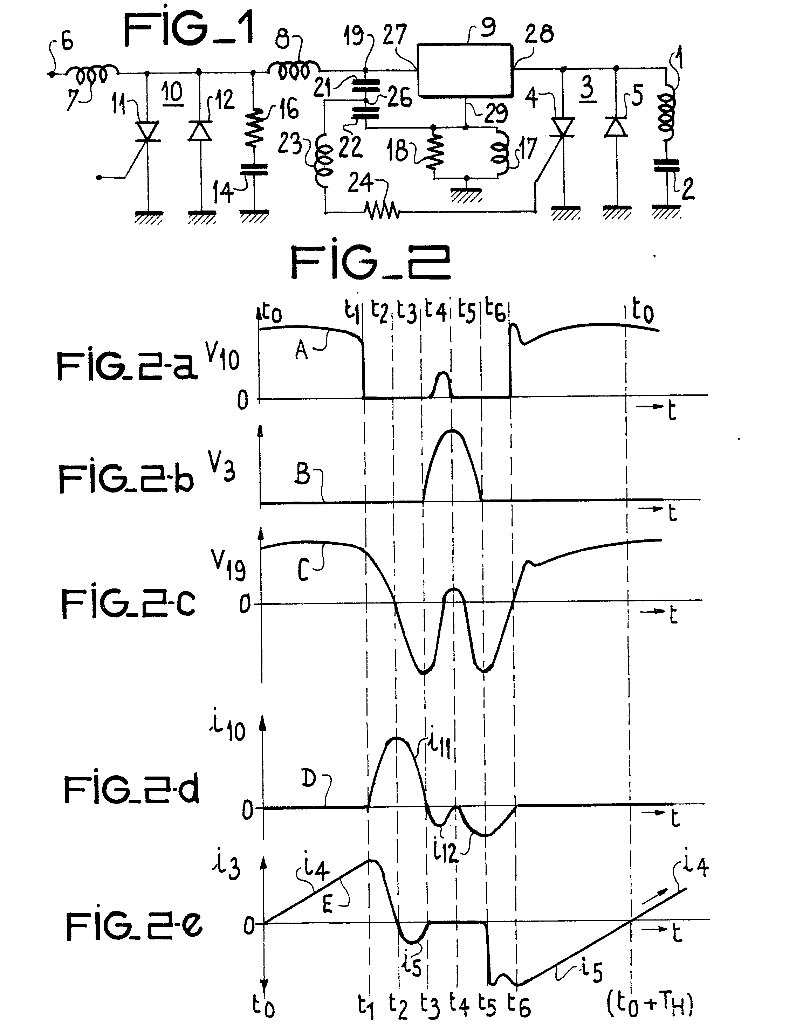

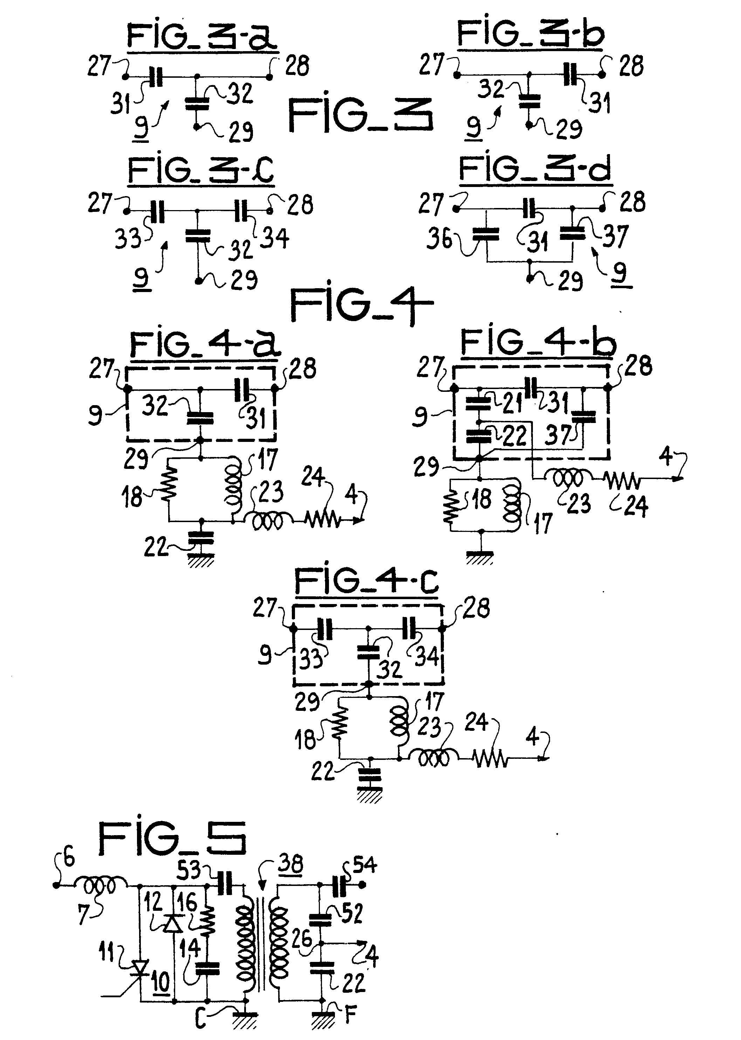

Le circuit de balayage de la figure 1 comprend un premier dispositif interrupteur bidirectionnel 3, connecté en parallèle sur le circuit de balayage proprement dit, qui est composé de l'inductance 1 représentant la bobine de déviation-ligne du tube à rayons cathodiques et d'un condensateur d'aller de balayage 2, montés en série, ce dernier alimentant la bobine 1 pendant l'aller du balayage. Ce condensateur d'aller de balayage 2 a une forte capacité afin de conserver au cours du fonctionnement du circuit une tension sensiblement constante. Le dispositif interrupteur bidirectionnel 3 constitué par un premier couple de thyristor 4 - diode 5 montés tête-bêche, est connecté aux bornes de l'inductance 1 et du condensateur 2 en série, et fonctionne comme interrupteur de balayage. Un deuxième dispositif interrupteur bidirectionnel 10 est relié au premier 3 par l'intermédiaire d'un circuit réactif composé d'une inductance 8 et d'un réseau capacitif 9 dont une borne 29 est reliée à la masse par l'intermédiaire d'un réseau d'amortissement 17, 18, et dont diverses variantes connues sont illustrées par les figures 3a, b, c et d. Le deuxième interrupteur 10 est, de préférence, constitué par un deuxième couple thyristor 11 - diode 12. Lorsqu'il se ferme, il fait d'abord passer un courant oscillant, provenant du circuit réactif 8, 9, dans le premier interrupteur 3, de façon à commander son ouverture par le blocage du thyristor 4 et ensuite il assure le transfert de l'énergie du circuit 8, 9 vers la bobine 1 et le condensateur 2. Une inductance 7 de forte valeur réunit le point commun du circuit réactif 8, 9 avec le deuxième interrupteur 10 à la source 6. Cette inductance 7 emmagasine l'énergie fournie par la source 6 pendant la fermeture du deuxième interrupteur 10 et assure la charge du réseau capacitif 9, pendant son ouverture. Un réseau d'amortissement 14, 16 monté en parallèle avec le deuxième interrupteur 10 limite le gradient de variation de la tension appliquée au thyristor 11. Ce réseau est essentiellement constitué d'une capacité 14 et d'une résistance 16 montées en série. Le réseau d'amortissement constitué d'une inductance 17 et d'une résistance 18 en parallèle, qui réunit la borne 29 à la masse, permet de limiter le courant dans le réseau capacitif 9.

La gâchette du second thyristor 11 est commandée de façon connue par l'oscillateur-ligne du récepteur (non représenté).

Selon l'invention, le thyristor 4 de l'interrupteur 3 est commandé sur sa gâchette par un signal élaboré à partir du signal disponible à la fonction 19 entre l'inductance 8 et le réseau capacitif 9. La tension au point 19 qui est élevée (plusieurs centaines de volts), est abaissée à une valeur compatible avec la commande du thyristor par un diviseur de tension capacitif 21, 22. Pour retarder la crête du courant de gâchette, comme il sera explicité plus loin, on monte en série, entre la borne de sortie 26 du diviseur capacitif 21, 22 et la gâchette du thyristor 4, une inductance 23 et une résistance 24.

Le fonctionnement général d'un circuit de ce type a été expliqué, notamment dans le brevet français 1.536.025. Les explications suivantes se rapportent principalement à l'attaque de la gâchette du thyristor 4, concernée par l'invention.

La figure 2 représente des diagrammes des formes d'onde en différents points du circuit. Les courbes A, B, C représentent les tensions respectivement aux bornes des interrupteurs 10 et 3 et au point 19 du schéma de la figure 1. Les courbes D et E l'intensité des courants respectivement dans les interrupteurs 10 et 3 (positives pour les thyristors 11 et 4 et négatives pour les diodes 12 et 5).

L'instant $t_0$ est pris au moment de l'inversion du sens du courant dans l'inductance de balayage 1, c'est-à-dire au moment où le thyristor 4 commence à conduire. A l'instant $t_1$ le thyristor 11 est amorcé, la tension à ses bornes devient nulle, et le circuit réactif 8, 9 se referme à travers les deux dispositifs interrupteurs 10 et 3. Le courant oscillatoire circulant dans le réseau réactif 8, 9 à travers l'interrupteur 10 fermé est superposé dans le thyristor 4 au courant parcourant l'inductance de balayage 1. La tension au point 19 passe à l'instant $t_2$ par zéro pour devenir ensuite négative, puis elle remonte selon la période de l'oscillation du circuit oscillant constitué par le circuit réactif 8, 9, l'inductance de balayage 1, et le dispositif 10. Mais la valeur maximale relative de cette tension $V_{19}$ n'atteindra pas à l'instant $t_4$ la valeur initiale qu'elle avait avant l'amorçage du thyristor 11. La tension au point 19 ne reprend sa valeur initiale qu'après une seconde oscillation d'un circuit oscillant formé alors par le circuit réactif 8, 9 et l'inductance de balayage 1, le courant passant alors par la diode 12 en bloquant le thyristor 11. Le thyristor 4 est polarisé à l'envers à partir de l'instant $t_2$, mais il est de nouveau soumis à une tension directe à partir de l'instant $t_3$. Les paramètres du circuit 8, 9 sont choisis pour que ce temps $t_3 - t_2$ soit supérieur au temps de récupération du thyristor 4. La polarisation négative de la gâchette du thyristor 4 doit commencer avant l'instant $t_2$ et se poursuivre jusqu'à l'instant $t_5$ au moins.

On voit que la tension $V_{19}$ au point 19 du schéma de la figure 1 (courbe C de la figure 2) peut avantageusement être utilisée pour élaborer le signal d'attaque de la gâchette du thyristor 4 à condition d'éliminer la crête positive dans l'intervalle $t_5 - t_3$, où son anode est positive. Cette tension $V_{19}$ est en effet positive de $t_6$ à $t_2 + T_H$ (où $T_H$ est une période de ligne) et négative de $t_2$ à $t_6$. Toutefois pendant ce dernier intervalle, au temps $t_4$, celle-ci peut redevenir positive. Cependant, en utilisant un réseau de condensateurs, il est possible d'aligner les tensions et d'obtenir une tension négative pendant tout l'intervalle entre $t_2$ et $t_6$, malgré la remontée à l'instant $t_4$.

Le dispositif d'attaque comprend donc un diviseur capacitif constitué par deux condensateurs 21 et 22

8

reliés en série entre le point 19 et la masse, à travers un réseau d'amortissement 17 et 18, et dont la borne de sortie 26 située au point intermédiaire entre les condensateurs 21 et 22 est reliée à la gâchette du thyristor 4 à travers l'inductance 23 et la résistance 24, montées en série.

La valeur des condensateurs 21 et 22 est choisie de manière à abaisser la tension du point 26 jusqu'à une valeur compatible avec la commande du thyristor. La fonction du réseau inductance 23 et résistance 24 est de déphaser la forme d'onde de tension $V_{19}$ divisée de façon à placer la crête du courant de gâchette à l'instant le plus favorable, c'est-à-dire approximativement à l'instant $t_o$. Le réseau d'amortissement constitué par l'inductance 17 en parallèle avec la résistance 18 n'intervient pas directement dans le fonctionnement du circuit d'attaque de la gâchette, mais il est nécessaire pour limiter la montée du courant à la fois dans le réseau capacitif 9 et le diviseur capacitif 21, 22.

Il existe plusieurs variantes de réalisation selon le montage adopté pour le réseau capacitif 9, certaines configurations permettant une simplification du montage.

Les figures 3a, 3b, 3c et 3d donnent les schémas de différentes configurations connues du réseau capacitif 9. Dans les montages des figures 3a et 3b qui sont les plus simples, un seul condensateur 31 relie les bornes 27 et 28 du réseau, tandis qu'un condensateur 32 relie la borne 29 (dite de masse) à un pôle du condensateur 31. Dans la figure 3c, les bornes 27 et 28 du réseau 9 en forme de T sont reliées par deux condensateurs 33 et 34 en série, tandis que la borne 29 est reliée par un condensateur 32 au pôle commun des condensateurs 33 et 34. Dans le montage de la figure 3d, les bornes 27 et 28 sont réunies ensemble par un seul condensateur 31 dont chacun des pôles est relié à la borne 29 par un condensateur respectivement 36 et 37, formant un réseau 9 en $\pi$.

La figure 4a représente un montage du circuit d'attaque du thyristor 4 conforme à l'invention, et adapté au réseau capacitif 9 de la figure 3b, remarquable par la présence d'un seul condensateur 31 entre les bornes 27 et 28 du réseau capacitif 9, et un seul condensateur 32 entre un pôle du condensateur et la borne 29 reliée à la masse par le réseau d'amortissement 17 et 18.

On voit sur cette figure 4a que le condensateur 32 du réseau capacitif 9 joue également le rôle du condensateur 21 du diviseur capacitif 21-22 de la figure 1 et que le condensateur 22 est inséré entre le réseau d'amortissement réuni à la borne 29 et la masse.

La figure 4b représente un montage du circuit d'attaque adapté à la configuration en $\pi$ du réseau capacitif illustré sur la figure 3d. Sur ce schéma on remarque que le condensateur 36 est remplacé par les deux condensateurs 21 et 22 du diviseur capacitif de la figure 1.

La figure 4c représente une autre réalisation adaptée au montage en T du réseau capacitif 9 illustré figure 3c, comportant deux condensateurs 33 et 34 en série entre les entrées 27 et 28. Dans ce montage le condensateur 32 du réseau capacitif 9 est également utilisé comme premier condensateur du diviseur capacitif (21, figure 1). Ce montage simplifié présente toutefois un léger inconvénient qui est constitué par le fait que la présence du condensateur 33 dans cette configuration a pour effet d'augmenter la remontée de la tension, à l'instant $t_4$ (courbe C figure 2) à la jonction des condensateurs 33, 34 et 32 et également aux bornes du condensateur 22. Or on a vu plus haut qu'il était nécessaire d'éviter une rémontée positive de cette tension à cet instant. Cette contrainte impose donc que le condensateur 33 ait une capacité beaucoup plus élevée que celle du condensateur 34.

Le circuit selon l'invention présente également un grand intérêt dans le cas où, dans le circuit de balayage, l'inductance 8 (figure 1) est remplacée par un transformateur. Cette disposition a pour but principal d'isoler galvaniquement la plus grande partie du circuit de la source 6. On voit que dans le cas d'un tel montage, il serait contraire au but recherché de connecter, par le circuit d'attaque de la gâchette du thyristor de balayage 4, la partie du circuit, que l'on s'est attaché à rendre "froide", à la partie "chaude" située entre le transformateur remplaçant l'inductance 8, et la source 6.

La figure 5 représente le schéma partiel d'un circuit de balayge comportant un transformateur d'isolement 38 à la place de l'inductance 8. On a représenté sur cette figure, notamment le transformateur 38, les condensateurs 52, 53 et 54 équivalents aux condensateurs 32, 33 et 34 du réseau capacitif 9, qui sont dispersés, et la sortie 26 de commande de la gâchette du thyristor 4, le reste du circuit de balayage étant le même que celui représenté figure 1. Le condensateur 53 est connecté ici en série avec l'enroulement primaire du transformateur 38, entre l'une des bornes de celui-ci et le second interrupteur 10, l'autre borne du primaire étant reliée, avec la cathode du second thyristor 11 et l'anode de la seconde diode 12, à la masse chaude C constituée par le pôle négatif de la source 6. Le condensateur 54 est relié à l'une des bornes de l'enroulement secondaire du transformateur 38, dont l'autre borne est reliée à la masse froide F du récepteur de télévision, qui est isolée du secteur. Le troisième condensateur 52 du réseau capacitif est monté
en série avec le second condensateur 22 du diviseur
capacitif et le montage série résultant est relié
aux bornes de l'enroulement secondaire. On voit que,
comme dans le cas du condensateur 32 de la figure 4c,
le condensateur 52 est utilisé également comme premier
condensateur 21 du diviseur capacitif (figure 1) composé
ici des condensateurs 22 et 52 dont le point commun 26
est relié au circuit de gâchette du thyristor 4.

12

## REVENDICATIONS

1. Circuit de balayage ligne pour récepteur de télévision, comportant :

- une bobine de déviation ligne (1) connectée en série avec un condensateur (2) d'aller de balayage,

- un premier interrupteur bidirectionnel (3) comportant un thyristor (4) et une diode (5) montés tête-bêche, ce premier interrupteur (3) étant connecté en parallèle avec l'ensemble formé par le déviateur ligne (1) et le condensateur (2) d'aller de balayage,

- un second interrupteur bidirectionnel (10) comportant un thyristor (11) et une diode (12) montés tête-bêche, et commandé par un signal provenant d'un circuit oscillateur à la fréquence ligne,

- un circuit réactif comportant une première inductance (8) en série avec un réseau capacitif (9), et liant électriquement la jonction anode du thyristor (4) et cathode de la diode (5) du premier interrupteur (3) à la jonction anode du thyristor (11) et cathode de la diode (12) du second interrupteur (10), ladite jonction du second interrupteur (10) étant d'autre part connectée à une source de tension continue (6) au travers d'une seconde inductance (7), et ce second interrupteur (10) permettant lorsqu'il est en position fermée, d'une part le passage d'un courant oscillant dans le premier interrupteur (3) de manière à permettre l'annulation du courant dans le thyristor (4) de ce premier interrupteur (3), et d'autre part le transfert de l'énergie de la source (6) vers la bobine de balayage ligne (1) associée au condensateur (2) d'aller de balayage, caractérisé en ce que le premier interrupteur (3) est commandé sur la gâchette de son thyristor (4) par un signal élaboré à partir du signal disponible à la jonction (19) de la première inductance (8) et du réseau capacitif (9) du circuit réactif.

2. Circuit selon la revendication 1, caractérisé en ce que le signal de commande de la gâchette du thyristor (4) du premier interrupteur (3) est prélevé aux bornes d'un troisième condensateur (22) d'un diviseur capacitif comportant un second condensateur (21) et ce troisième condensateur (22) en série, et étant connecté entre la jonction (19) du circuit réactif et la jonction commune reliée à la masse des cathodes des deux thyristors (4, 11) des interrupteurs (3, 10).

3. Circuit selon la revendication 2, du type dans lequel le réseau capacitif (9) comporte un quatrième condensateur (31) connecté entre sa première (27) et sa seconde (28) borne qui sont respectivement réunies à la jonction (19) du circuit réactif (8, 9) et au premier interrupteur (3), et un cinquième condensateur (32) connecté entre l'une des première (27) et seconde (28) bornes et une troisième borne (29) du réseau capacitif (9) qui est habituellement reliée à la masse, éventuellement par l'intermédiaire d'un réseau d'amortissement comprenant une troisième inductance (17) et une résistance (18) en parallèle, caractérisé en ce que le diviseur capacitif comprend le cinquième condensateur (32) du réseau capacitif (9) et le troisième condensateur (22) qui est inséré entre la masse et la troisième borne (29) de celui-ci. (Figure 4a et Figure 3b)

4. Circuit selon la revendication 2, du type dans lequel le réseau capacitif (9) comporte un quatrième, un cinquième et un sixième condensateur (31, 36, 37) montés en "ᴛᴛ", dont le quatrième (31) est connecté entre ses première (27) et seconde (28) bornes, dont le cinquième (36) est connecté entre ses première (27) et troisième (29) bornes et dont le sixième (37) est connecté entre ses seconde (28) et troisième (29) bornes, caractérisé en ce que le cinquième condensateur (36) est composé des second (21) et troisième (22) condensateurs en série du diviseur capacitif, le point commun de ces second (21) et troisième (22) condensateurs étant couplé à la gâchette du thyristor (4) du premier interrupteur (3). (Figure 4b et Figure 3d)

5. Circuit selon la revendication 2, du type dans lequel le réseau capacitif (9) comporte un quatrième, un cinquième et un sixième condensateur (33, 34, 32) montés en "T", dont les quatrième (33) et cinquième (34) sont correctés en série entre ses première (27) et seconde 28) bornes et dont le sixième (32) réunit la jonction du quatrième (33) et du cinquième (34) à la troisième borne (29) de ce réseau (9), caractérisé en ce que le diviseur capacitif comprend le sixième condensateur (32) du réseau capacitif (9) et le troisième condensateur (22) inséré entre la masse et la troisième borne (29) de celui-ci. (Figure 4c et Figure 3e)

6. Circuit selon la revendication 1, dans lequel la première inductance (8) du circuit réactif (8, 9) est composé d'un transformateur d'isolement (38), permettant d'isoler galvaniquement la partie du circuit de balayage incluant la bobine de déviation (1) et le premier interrupteur (3), de la source de tension continue (6), et dans lequel le réseau capacitif comporte un second condensateur (53) en série avec l'enroulement primaire du transformateur (38), un troisième condensateur (54) en série avec l'enroulement secondaire de ce même transformateur (38) et un quatrième condensateur connecté entre les bornes de cet enroulement secondaire, caractérisé en ce que ce quatrième condensateur est constitué par un diviseur capacitif comprenant un montage série de deux condensateurs (52, 22) reliés entre les bornes de l'enroulement secondaire, le point commun de ces deux condensateurs (52, 22) du montage série étant couplé à la gâchette du thyristor (4) du premier interrupteur (3). (Figure 5)

7. Récepteur de télévision comportant un circuit de balayage-ligne suivant l'une quelconque des revendications précédentes.

FIG_1

FIG_2

FIG_2-a $V_{10}$

FIG_2-b $V_3$

FIG_2-c $V_{19}$

FIG_2-d $i_{10}$

FIG_2-e $i_3$

FIG_3

FIG_3-a

FIG_3-b

FIG_3-c

FIG_3-d

FIG_4

FIG_4-a

FIG_4-b

FIG_4-c

FIG_5

Office européen
des brevets

**RAPPORT DE RECHERCHE EUROPEENNE**

00 14 108

Numéro de la demande

EP 80 40 0012

| | DOCUMENTS CONSIDERES COMME PERTINENTS | | | CLASSEMENT DE LA DEMANDE (Int. Cl. ³) |
|---|---|---|---|---|
| Catégorie | Citation du document avec indication, en cas de besoin, des parties pertinentes | Revendica-tion concernee | | |
| | DE - A - 2 524 082 (PHILIPS)<br>* Figure 1; page 2, lignes 1-27; page 3, lignes 6-34; page 4, lignes 12-17 *<br>--<br>FR - A - 2 324 167 (RCA)<br>* Figures 1,2,4,5; de page 5, ligne 5 à page 6, ligne 6; de page 6, ligne 30 à page 8, ligne 6 *<br>--<br>FR - A - 2 313 830 (INTERNATIONAL STANDARD ELECTRIC)<br>* Figure unique *<br>---- | 1<br><br>1<br><br>1,2 | | H 03 K   4/83 |

DOMAINES TECHNIQUES
RECHERCHES (Int. Cl. ³)

H 03 K   4/83

CATEGORIE DES
DOCUMENTS CITES

X: particulièrement pertinent
A: arrière-plan technologique
O: divulgation non-écrite
P: document intercalaire
T: théorie ou principe à la base de l'invention
E: demande faisant interférence
D: document cité dans la demande
L: document cité pour d'autres raisons
&: membre de la même famille, document correspondant

Le présent rapport de recherche a été établi pour toutes les revendications

| Lieu de la recherche | Date d'achevement de la recherche | Examinateur |
|---|---|---|
| La Haye | 14-04-1980 | GYSEN |

OEB Form 1503.1   06.78